# EUROPEAN PATENT SPECIFICATION

(11) **EP 0 805 498 B1**
(45) Date of publication and mention of the grant of the patent: **08.08.2001**
(21) Application number: 97106992.7
(22) Date of filing: 28.04.1997
(51) Int. Cl.: H01L 29/778, H01L 29/423

(54) **High electron mobility transistor and method of manufacturing same**
Transistor mit hoher Elektronenbeweglichkeit und Verfahren zur Herstellung
Transistor à grande mobilité électronique et méthode de fabrication

(30) Priority: 02.05.1996 JP 13590296
(43) Date of publication of application: 05.11.1997
(73) Proprietor: HONDA GIKEN KOGYO KABUSHIKI KAISHA, Minato-ku Tokyo (JP)
(72) Inventor: Kamiyama, Tomoyuki, Wako-shi, Saitama-ken (JP)
(74) Representative: Prechtel, Jörg, Dipl.-Phys. Dr.

(56) References cited:
- EP-A- 0 203 225
- EP-A- 0 469 768
- EP-A- 0 522 952
- PATENT ABSTRACTS OF JAPAN vol. 16, no. 364 (E-1244), 6 August 1992 & JP 04 115555 A (MITSUBISHI ELECTRIC CORP), 16 April 1992,
- PATENT ABSTRACTS OF JAPAN vol. 17, no. 241 (E-1364), 14 May 1993 & JP 04 365333 A (MATSUSHITA ELECTRIC IND CO LTD), 17 December 1992,
- ELECTRONICS LETTERS, vol. 30, no. 19, 15 September 1994, STEVENAGE GB, pages 1628-1629, XP000466482 W. PATRICK: "Modified T-gates incorporating microairbridges to avoid mesa sidewall contact in AlInAs/GaInAs HEMTs."
- S.M. SZE: "Physics of Semiconductor Devices 404, 405", JOHN WILEY AND SONS, NEW YORK

## Description

The present invention relates to a high electron mobility transistor (HEMT) for use in a millimeter-wavelength-band high-frequency amplifier or the like, and a method of manufacturing such a high electron mobility transistor.

There have been developed high electron mobility transistors (HEMT) which have a channel layer of high electron mobility InGaAs (indium gallium arsenide). The high electron mobility transistors include a double-heterojunction channel structure which comprises a thin channel layer of InGaAs disposed intermediate between wide-band gap layers of AlGaAs (aluminum gallium arsenide).

In the high electron mobility transistors, the elements are separated by mesa etching, and an extension of a gate electrode extends over a mesa slope, produced by mesa etching, to a gate pad. The extension of the gate electrode is held in contact with the channel layer of InGaAs which is exposed on the mesa slope. To prevent a leakage current caused by such contact from increasing, it has been proposed to form an electrically insulating film comprising an SiO₂ film and a silicon nitride film between the mesa slope and the gate electrode extension, in a heterojunction field-effect transistor disclosed in JP-A-4-365333.

According to the proposed structure disclosed in the above publication, the electrically insulating film disposed between the mesa slope and the gate electrode extension is effective to reduce the leakage current. However, the SiO₂ film and the electrically insulating film produce a parasitic capacitance between the gate electrode extension and the channel layer, tending to bypassing high-frequency signals. As a result, the disclosed heterojunction field-effect transistor has poor high-frequency characteristics.

Another possibility to avoid a sidewall leakage path from gate to channel is disclosed in "Modified T-Gates Incorporating Micro-Airbridges to Avoid Mesa Sidewall Contact in AllnAs/GalnAs HEMTs" by W. Patrick, Electronic Letters, Vol. 30, No. 19, 1994, pp. 1628, 1629. In this article, an airbridge structure is suggested which provides an airgap between a gate extension and a channel layer in the region of a mesa sideslope. The airgap prevents leakage currents from flowing between the gate extension and the channel layer. No insulating layer is provided on the mesa sidewall beneath the gate extension.

EP O 522 952 A2 discloses, amongst others, a HEMT transistor. This document does not deal with capacitance problems in the region of a mesa sidewall of the HEMT and does not even show a mesa structure.

Finally, JP-A-4-115555 teaches to reduce a parasitic capacitance in semiconductor devices by providing an airbridge wiring. However, this document does not disclose a HEMT having a mesa structure and does not deal with the high-frequency characteristics of such a HEMT.

It is an object of the present invention to provide a high electron mobility transistor which has a reduced gate parasitic capacitance for improved high-frequency characteristics.

According to the present invention, there is provided a high electron mobility transistor according to claim 1.

The high electron mobility transistor may further comprise a superlattice buffer layer, the lower wide-band gap layer being disposed on the superlattice buffer layer, and a gate pad disposed on the superlattice buffer layer and spaced from the mesa structure, the extension being connected to the gate pad.

The upper and lower wide-band gap layers may include silicon planar-doped layers, respectively.

According to the present invention, there is also provided a method, of manufacturing a high electron mobility transistor according to claim 5.

The method may further comprise the steps of forming a superlattice buffer layer, and depositing a gate pad connected to the extension on the superlattice buffer layer in spaced relation to the mesa structure.

The method may further comprise the step of forming silicon planar-doped layers respectively in the upper and lower wide-band gap layers.

The above and other objects, features, and advantages of the present invention will become apparent from the following description when taken in conjunction with the accompanying drawings which illustrate a preferred embodiment of the present invention by way of example.
FIG. 1 is a fragmentary perspective view of a high electron mobility transistor according to the present invention;
FIG. 2(A) through 2(F) are fragmentary cross-sectional views showing successive steps of a process of manufacturing the high electron mobility transistor according to the present invention; and
FIG. 3 is a fragmentary cross-sectional view of a modified high electron mobility transistor according to the present invention.

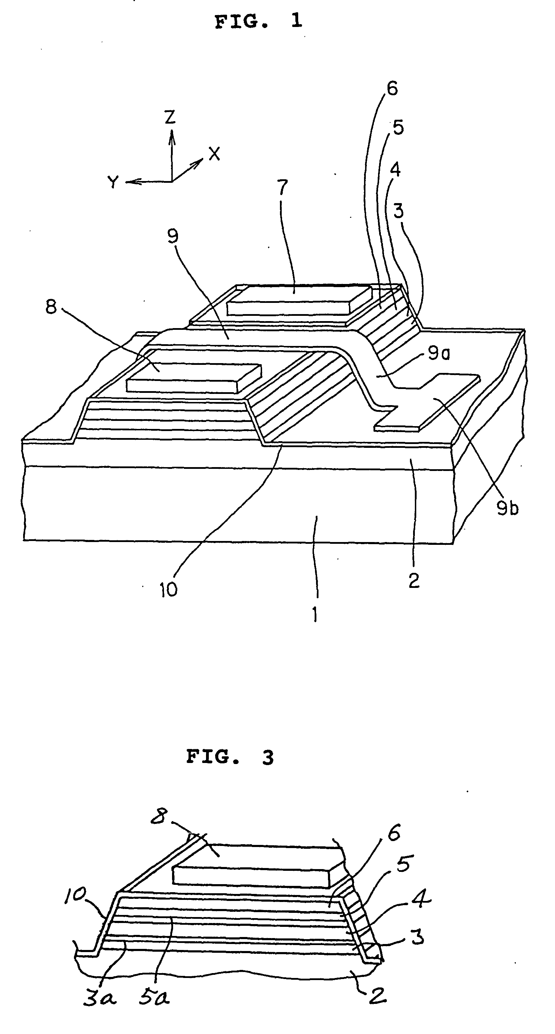

As shown in FIG. 1, a high electron mobility transistor according to the present invention comprises a semi-insulating GaAs substrate 1, a superlattice buffer layer 2 disposed on the semi-insulating GaAs substrate 1, and a double-heterojunction structure disposed on the superlattice buffer layer 2 and including a pair of lower and upper high-resistance AlGaAs wide-band gap layers 3, 5 and an InGaAs channel layer 4 disposed between the lower and upper AlGaAs wide-band gap layers 3, 5. Each of the AlGaAs wide-band gap layers 3, 5 has a thickness of about 300 Å, and is made of AlₓGa₁₋ₓAs (0.2 < x < 0.3). The lower AlGaAs wide-band gap layer 3 serves as a carrier supply for the channel layer 4.

The high electron mobility transistor also includes an n⁺ GaAs contact layer 6 disposed on the upper AlGaAs wide-band gap layer 5 is doped with Si at a concentration of 5 × 10¹⁸ cm⁻³ and has a thickness of 500 Å. Source and drain electrodes 7, 8 are disposed on the n⁺ GaAs contact layer 6 and separated from each other by a recess defined therebetween. A gate electrode 9 is disposed in the recess and has an extension 9a which is connected to a gate pad 9b mounted on the superlattice buffer layer 2.

As shown in FIG. 1, the wide-band gap layers 3, 5, the InGaAs channel layer 4, the contact layer 6, and the source and drain electrodes 7, 8 are formed as a mesa structure or land on the buffer layer 2 by mesa etching (described later on). The gate pad 9b is spaced from the mesa structure. An insulating film 10 of SiO₂ is disposed on the buffer layer 2 and surfaces, including side slopes, of the mesa structure. The extension 9a of the gate electrode 9 extends in overhanging and spaced relation to the side slopes of the mesa structure, and has an end joined to the gate pad 9b that is positioned in a valley which is formed by the mesa etching. Since the extension 9a is spaced by an air gap from the side slopes of the mesa structure, any parasitic capacitance between the extension 9a and the channel layer 4 is relatively small as the air layer whose permittivity is 1 is interposed therebetween.

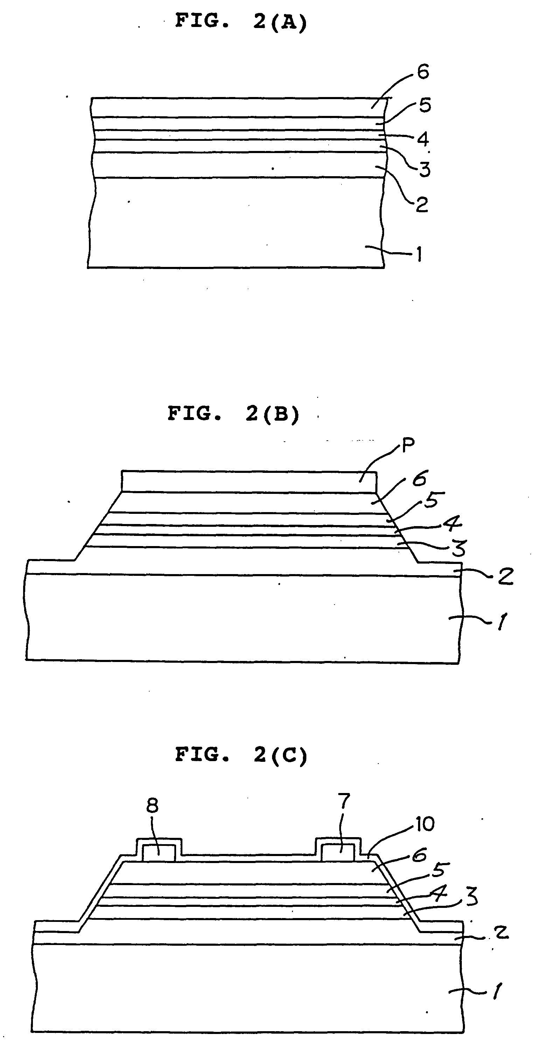

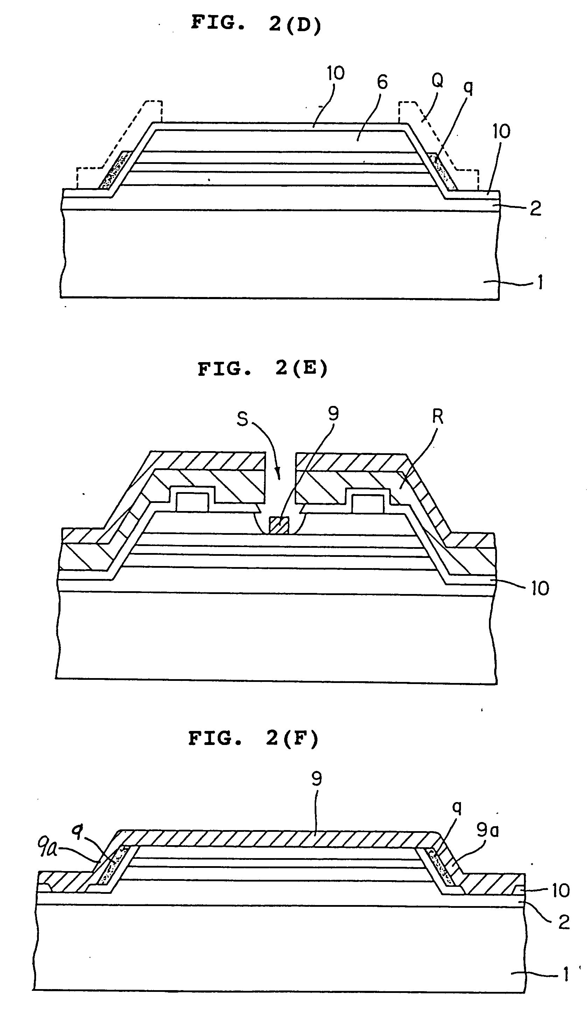

FIGS. 2(A) through 2(F) show successive steps of a process of manufacturing the high electron mobility transistor according to the present invention. The process of manufacturing the high electron mobility transistor will be described below with reference to FIGS. 2(A) through 2(F).

As shown in FIG. 2(A), a superlattice buffer 2 is deposited on a GaAs substrate 1, and an double heterojunction structure comprising an AlₓGa₁₋ₓAs wide-band gap layer 3 where the aluminum ratio x ranges from 0.2 to 0.3 and which has a thickness of about 300 Å, an InGaAs channel layer 4 having a thickness of about 100 Å, and an AlGaAs layer 5 having a thickness of 300 Å is deposited on the superlattice buffer 2. An n⁺ GaAs contact layer 6 having a thickness of 500 Å is deposited on the AlGaAs layer 5.

Then, as shown in FIG. 2(B), a photoresist film P is deposited on the n⁺ GaAs contact layer 6, and using the photoresist film P as a mask, the assembly formed so far is subject to mesa etching until the superlattice buffer 2 is exposed. The superlattice buffer 2, the wide-band gap layers 3, 5, the channel layer 4, and the contact layer 6 below the photoresist film P are now left as a mesa structure or land.

Thereafter, as shown in FIG. 2(C), a source electrode 7 and a drain electrode 8 are deposited on the contact layer 6 by vacuum evaporation. Subsequently, a passivation film or electrically insulating film 10 of SiO₂ is deposited to a thickness of about 500 Å on the entire surface formed so far by plasma CVD (Chemical Vapor Deposition).

Then, as shown in FIG. 2(D), which shows a cross section of the mesa structure along a Y - Z plane in an orthogonal three-dimensional coordinate system XYZ shown in FIG. 1, photoresist layers Q are deposited on respective opposite side slopes of the mesa structure as indicated by the dotted lines. Then, the photoresist layers Q are etched back by dry etching until they are reduced to photoresist layers q below the contact layer 6. A this time, the internal layers of the mesa structure are protected from damage due to the plasma etching by the SiO₂ film 10 that covers the mesa structure.

Then, as shown in FIG. 2(E), which shows a cross section of the mesa structure along an X - Z plane in the orthogonal three-dimensional coordinate system XYZ shown in FIG. 1, an electron-beam photoresist layer R is deposited on the SiO₂ film 10, and a gate pattern S having a small width is formed in the photoresist layer R by an electron beam. Using the gate pattern as a mask, the SiO₂ film 10 is subjected, to wet etching. Then, the contact layer 6 is selectively etched to form a recess therein by an etching solution which comprises a mixture of ammonia water and hydrogen peroxide water mixed at a ratio of 1 to 4000 or more and diluted by water.

Then, titanium (Ti) and gold (Au) are evaporated successively into the recess through the gate pattern S by a resistance-heating vacuum evaporation system, forming a gate electrode 9 of Ti and Au in the recess.

As shown in FIG. 2(F), which shows a cross section of the mesa structure along the Y - Z plane in an orthogonal three-dimensional coordinate system XYZ shown in FIG. 1, the gate electrode 9 has extensions 9a disposed on the photoresist layers q left on the side slopes of the mesa structure.

Then, the photoresist layer R is melted by a chemical, and the melted photoresist layer R and gate metal layers deposited thereon are lifted off. At the same time, the photoresist layers q interposed between the extensions 9a of the gate electrode 9 and the side slopes of the mesa structure which are covered with the SiO₂ film 10 are melted and removed by the chemical. As a result, the extensions 9a of the gate electrode 9 remain in overhanging and spaced relation to the side slopes of the mesa structure. Finally, the SiO₂ film 10 on the source and drain electrodes 7, 8 is selectively removed, and gate pads 9b connected to the extensions 9 are formed on the superlattice buffer layer 2. The high electron mobility transistor according to the present invention is now completed.

In the illustrated embodiment, the high electron mobility transistor according to the present invention includes the upper and lower wide-band gap layers 5, 3 disposed as carrier supply layers above and below the channel layer 4. However, the principles of the present invention are also applicable to a high electron mobility transistor which includes silicon planar-doped layers 5a, 3a respectively in the upper and lower wide-band gap layers 5, 3, as shown in FIG. 3.

Although a certain preferred embodiment of the present invention has been shown and described in detail, it should be understood that various changes and modifications may be made therein without departing from the scope of the appended claims.

A high electron mobility transistor includes a channel layer for developing therein the two-dimentional electron gas layer, upper and lower wide-band gap layers disposed respectively over and beneath the channel layer, and a contact layer disposed on the upper wide-band gap layer for contact with source and drain electrodes. The channel layer, the upper and lower wide-band gap layers, and the contact layer being are etched so as to be formed into a mesa structure including a side slope. The contact layer has a recess defined therein which divides the contact layer. A gate electrode is disposed in the recess and has an extension spaced in overhanging relation from the side slope by an air gap. A film of SiO₂ is disposed on the side slope. The high electron mobility transistor also includes a superlattice buffer layer on which the lower wide-band gap layer is disposed, and a gate pad disposed on the superlattice buffer layer and spaced from the mesa structure, the extension being connected to the gate pad.

## Claims

1. A high electron mobility transistor comprising:
- a channel layer (4) for developing therein a two-dimensional electron gas layer,
- upper and lower wide-band gap layers (3, 5) disposed respectively over and beneath said channel layer (4),
- a contact layer (6) disposed on the upper wide-band gap layer (5) for contact with source and drain electrodes (7, 8), said channel layer (4), said upper and lower wide-band gap layers (3, 5), and said contact layer (6) being jointly of a mesa structure including a side slope, said contact layer (6) having a recess defined therein which divides the contact layer (6),
- an insulating film (10) disposed on said side slope, and
- a gate electrode (9) disposed in said recess and having an extension (9a) extending over said insulating film (10) along said side slope,
characterized in that
said extension (9a) is spaced in overhanging relation from said insulating film (10) by an air gap.

2. A high electron mobility transistor according to claim 1, wherein said insulating film (10) is a film of SiO₂.

3. A high electron mobility transistor according to claim 1 or 2, further comprising a superlattice buffer layer (2), said lower wide-band gap layer (3) being disposed on said superlattice buffer layer (2), and a gate pad (9b) disposed on said superlattice buffer layer (2) and spaced from said mesa structure, said extension (9a) being connected to said gate pad (9b).

4. A high electron mobility transistor according to one of claims 1-3, wherein said upper and lower wide-band gap layers (3,5) include silicon planar-doped layers (3a, 5a), respectively.

5. A method of manufacturing a high electron mobility transistor, comprising the steps of:
forming a lower wide-band gap layer (3);
depositing a channel layer (4) on said lower wide-band gap layer (3);
depositing an upper wide-band gap layer (5) on said channel layer (4);
depositing a contact layer (6) on said upper wide-band gap layer (5);
etching said lower wide-band gap layer (3), said channel layer (4), said upper wide-band gap layer (5), and said contact layer (6) by mesa etching to form a mesa structure which comprises said lower wide-band gap layer (3), said channel layer (4), said upper wide-band gap layer (5), and said contact layer (6), said mesa structure having a side slope;
depositing an insulating film (10) on said side slope;
forming a recess in said contact layer (6);
depositing a gate electrode (9) in said recess, said gate electrode having an extension (9a) extending over said insulating film (10) along said side slope;
characterized by :
depositing a photoresist layer (9) on said insulating film (10) at said side slope before depositing said gate electrode (9) ; and
removing said photoresist layer (9) after depositing said gate electrode (9) thereby leaving said extension (9a) spaced in overhanging relation to said insulating film (10) by an air gap.
6. A method according to claim 5, further comprising the steps of:
forming a superlattice buffer layer (2); and
depositing a gate pad (9b) connected to said extension (9a) on said superlattice buffer layer (2) in spaced relation to said mesa structure.
7. A method according to claim 5 or 6, further comprising the step of:
forming silicon planar-doped layers (3a, 5a) respectively in said upper and lower wide-band gap layers (3, 5).

## Patentansprüche

1. Transistor hoher Elektronenbeweglichkeit, umfassend:
- eine Kanalschicht (4), um darin eine zweidimensionale Elektronengasschicht zu entwickeln,
- eine obere und eine untere Schicht großen Bandabstands (3, 5), welche oberhalb bzw. unterhalb der Kanalschicht (4) angeordnet sind,
- eine auf der oberen Schicht großen Bandabstands (5) angeordnete Kontaktschicht (6) zum Kontakt mit Source- und Drain-Elektroden (7, 8), wobei die Kanalschicht (4), die obere und die untere Schicht großen Bandabstands (3, 5) sowie die Kontaktschicht (6) einer Mesastruktur mit einer Seitenschräge angehören, wobei in der Kontaktschicht (6) eine Aushehmung ausgebildet ist, welche die Kontaktschicht (6) unterteilt,
- einen auf der Seitenschräge angeordneten lsolierfilm (10) sowie
- eine in der Ausnehmung angeordnete Gate-Elektrode (9), welche einen Fortsatz (9a) aufweist, der entlang der Seitenschräge über dem lsolierfilm (10) verläuft,
dadurch gekennzeichnet, dass der Fortsatz (9a) den lsolierfilm (10) durch eine Luftbrücke im Abstand überragt.

2. Transistor hoher Elektronenbeweglichkeit nach Anspruch 1, bei dem der lsolierfilm (10) ein Film aus SiO₂ ist.

3. Transistor hoher Elektronenbeweglichkeit nach Anspruch 1 oder 2, ferner umfassend eine Übergitterpufferschicht (2), wobei die untere Schicht großen Bandabstands (3) auf der Übergitterpufferschicht (2) angeordnet ist, sowie ein auf der Übergitterpufferschicht (2) im Abstand von der Mesastruktur angeordnetes Gate-Anschlussfeld (9b), wobei der Fortsatz (9a) mit dem Gate-Anschlussfeld (9b) verbunden ist.

4. Transistor hoher Elektronenbeweglichkeit nach einem der Ansprüche 1 bis 3, bei dem die obere und die untere Schicht großen Bandabstands (3, 5) Silicium-Planardotierungsschichten (3a, 5a) umfassen.

5. Verfahren zur Herstellung eines Transistors hoher Elektronenbeweglichkeit, umfassend die Schritte:
- Bilden einer unteren Schicht großen Bandabstands (3),
- Aufbringen einer Kanalschicht (4) auf die untere Schicht großen Bandabstands (3),
- Aufbringen einer oberen Schicht großen Bandabstands (5) auf die Kanalschicht (4),
- Aufbringen einer Kontaktschicht (6) auf die obere Schicht großen Bandabstands (5),
- Ätzen der unteren Schicht großen Bandabstands (3), der Kanalschicht (4), der oberen Schicht großen Bandabstands (5) und der Kontaktschicht (6) durch Mesaätzen, um eine Mesastruktur zu bilden, welche die untere Schicht großen Bandabstands (3), die Kanalschicht (4), die obere Schicht großen Bandabstands (5) und die Kontaktschicht (6) umfasst, wobei die Mesastruktur eine Seitenschräge aufweist,
- Aufbringen eines Isolierfilms (10) auf die Seitenschräge,
- Bilden einer Ausnehmung in der Kontaktschicht (6),
- Anbringen einer Gate-Elektrode (9) in der Ausnehmung, wobei die Gate-Elektrode einen Fortsatz (9a) aufweist, welcher entlang der Seitenschräge über dem lsolierfilm (10) verläuft,
gekennzeichnet durch:
- Aufbringen einer Fotolackschicht (q) auf den lsolierfilm (10) an der Seitenschräge vor der Anbringung der Gate-Elektrode (9) und
- Entfernen der Fotolackschicht (q) nach Anbringen der Gate-Elektrode (9), wodurch der Fortsatz (9a) den lsolierfilm (10) durch eine Luftbrücke im Abstand überragend zurückbleibt.

6. Verfahren nach Anspruch 5, ferner umfassend die Schritte:
- Bilden einer Übergitterpufferschicht (2) und
- Aufbringen eines mit dem Fortsatz (9a) verbundenen Gate-Anschlussfelds (9b) auf der Übergitterpufferschicht (2) im Abstand von der Mesastruktur.

7. Verfahren nach Anspruch 5 oder 6, ferner umfassend den Schritt: Bilden von Silicium-Planardotierungsschichten (3a, 5a) in der oberen und der unteren Schicht großen Bandabstands (3, 5).

## Revendications

1. Transistor à grande mobilité électronique, comprenant :
- une couche de canal (4) pour développer en son sein une couche de gaz électronique à deux dimensions,
- des couches de large bande interdite supérieure et inférieure (3, 5) respectivement disposées au-dessus et au-dessous de ladite couche de canal (4),
- une couche de contact (6) disposée sur la couche de large bande interdite supérieure (5) pour contact avec des électrodes de source et de drain (7, 8), ladite couche de canal (4), lesdites couches de large bande interdite supérieure et inférieure (3, 5), et ladite couche de contact (6) réalisant conjointement une structure mésa incluant une pente latérale, ladite couche de contact (6) ayant une partie en retrait définie en son sein qui divise la couche de contact (6),
- un film isolant (10) disposé sur ladite pente latérale, et
- une électrode de grille (9) disposée dans ladite partie en retrait et ayant une extension (9a) s'étendant sur ledit film isolant (10) le long de ladite pente latérale,
caractérisé en ce que
ladite extension (9a) est espacée dans une relation en surplomb par rapport audit film isolant (10) d'un espacement d'air.

2. Transistor à grande mobilité électronique selon la revendication 1, dans lequel ledit film isolant (10) est un film de SiO₂.

3. Transistor à grande mobilité électronique selon la revendication 1 ou 2, comprenant de plus une couche tampon de super réseau cristallin (2), ladite couche de large bande interdite inférieure (3) étant disposée sur ladite couche tampon de super réseau cristallin (2), et une plage de connexion de grille (9b) disposée sur ladite couche tampon de super réseau cristallin (2) et espacée de ladite structure mésa, ladite extension (9a) étant reliée à ladite plage de connexion de grille (9b).

4. Transistor à grande mobilité électronique, selon l'une des revendications 1 à 3, dans lequel lesdites couches de large bande interdite supérieure et inférieure (3, 5) comprennent respectivement des couches dopées au silicium par procédé planar (3a, 5a).

5. Procédé de fabrication d'un transistor à grande mobilité électronique, comprenant les étapes suivantes :
la formation d'une couche de large bande interdite inférieure (3) ;
le dépôt d'une couche de canal (4) sur ladite couche de large bande interdite inférieure (3) ;
le dépôt d'une couche de large bande interdite supérieure (5) sur ladite couche de canal (4) ;
le dépôt d'une couche de contact (6) sur ladite couche de large bande interdite supérieure (5) ;
l'attaque de ladite couche de large bande interdite inférieure (3), ladite couche de canal (4), ladite couche de large bande interdite supérieure (5), et ladite couche de contact (6) par une attaque mésa pour former une structure mésa qui comprend ladite couche de large bande interdite inférieure (3), ladite couche de canal (4), ladite couche de large bande interdite supérieure (5), et ladite couche de contact (6), ladite structure mésa ayant une pente latérale ;
le dépôt d'un film isolant (10) sur ladite pente latérale ;
la formation d'une partie en retrait dans ladite couche de contact (6) ;
le dépôt d'une électrode de grille (9) dans ladite partie en retrait, ladite électrode de grille ayant une extension (9a) s'étendant au-dessus dudit film isolant (10) le long de ladite pente latérale ;
caractérisé par :
le dépôt d'une couche de photorésist (q) sur ledit film isolant (10) au niveau de ladite pente latérale avant le dépôt de ladite électrode de grille (9) ; et
l'enlèvement de ladite couche de photorésist (q) après le dépôt de ladite électrode de grille (9) laissant de ce fait ladite extension (9a) espacée dans une relation en surplomb par rapport audit film isolant (10) d'un espacement d'air.

6. Procédé selon la revendication 5, comprenant de plus les étapes suivantes :
la formation d'une couche tampon de super réseau cristallin (2) ; et
le dépôt d'une plage de connexion de grille (9b) reliée à ladite extension (9a) sur ladite couche tampon de super réseau cristallin (2) dans une relation espacée par rapport à ladite structure mésa.

7. Procédé selon la revendication 5 ou 6, comprenant de plus l'étape suivante
la formation de couches dopées au silicium par procédé planar (3a, 5a) respectivement dans lesdites couches de large bande interdite supérieure et inférieure (3, 5).
